# EUROPEAN PATENT APPLICATION

(11) **EP 4 715 406 A1**
(43) Date of publication of application: **25.03.2026**
(21) Application number: 25199354.9
(22) Date of filing: 01.09.2025
(51) Int. Cl.: G01R 31/367, G01R 31/392, G06N 3/08, H01M 10/48

(54) **SYSTEM AND METHOD FOR PREDICTING LIFE OF BATTERY**

(30) Priority: 13.09.2024 KR 20240126138
(71) Applicant: SAMSUNG SDI CO., LTD., Yongin-si, Gyeonggi-do 17084 (KR)
(72) Inventor: LEE, Dongryul, 17084 Yongin-Si (KR); JANG, Junho, 17084 Yongin-si (KR); KIM, Haemin, 17084 Yongin-Si (KR); KO, Younghoon, 17084 Yongin-si (KR); YI, Sangkoan, 17084 Yongin-si (KR); LEE, Yujin, 17084 Yongin-Si (KR); KWON, Youngwoong, 17084 Yongin-Si (KR)
(74) Representative: Maiwald GmbH

(57) **Abstract**

The present disclosure relates to a system for predicting a life of a battery including a training data generation device configured to generate first data comprising life data of a reference battery and profile data for each battery degradation mode, a prediction model generation device configured to generate one or more life prediction models to predict profile data for each battery degradation mode with initial life data of a target battery as input, based on the first data, and a life prediction device configured to predict a life of the target battery based on second data comprising profile data for each battery degradation mode predicted by the one or more life prediction models based on the initial life data of the target battery.

## Description

### FIELD

Aspects of embodiments of the present disclosure relate to a system and method for predicting the life of a battery.

### DESCRIPTION OF THE RELATED ART

When developing a battery or secondary battery, charging and discharging can be performed repetitively under conditions and for a time similar to the actual usage environment of the battery so that the life of the battery is guaranteed. In this way, by having the life of a battery (the residual rate of the capacity) measured, the long-term life of the battery can be assessed. Recently, as the frequency of exposure of batteries to operating environments where degradation is accelerated increases (e.g., fast charging, fast discharging, low or high temperature environments), it is desirable to predict a degradation state more accurately for the safety and increased service life of the battery.

The above information disclosed in this Background section is for enhancement of understanding of the background of the present disclosure, and therefore, it may contain information that does not constitute related (or prior) art.

### SUMMARY

A problem to be solved by the present disclosure is to provide a system and method for predicting the life of a battery for solving the above problems.

These and other aspects and features of the present disclosure will be described in or will be apparent from the following description of embodiments of the present disclosure.

In order to solve the technical problems above, a system for predicting a life of a battery in accordance with some embodiments of the present disclosure may include a training data generation device configured to generate first data comprising life data of a reference battery and profile data for each battery degradation mode, a prediction model generation device configured to generate one or more life prediction models to predict profile data for each battery degradation mode with initial life data of a target battery as input, based on the first data, and a life prediction device configured to predict a life of the target battery based on second data comprising profile data for each battery degradation mode predicted by the one or more life prediction models based on the initial life data of the target battery.

According to some embodiments, the prediction model generation device may include a model training module configured to train the one or more life prediction models to predict profile data for each battery degradation mode with the life data of the reference battery as input, based on the first data, and a degradation mode analysis module configured to determine a life prediction model for verification corresponding to major degradation factors based on the second data comprising profile data for each battery degradation mode outputted by the one or more life prediction models with the initial life data of the target battery as input.

According to some embodiments, the degradation mode analysis module may be configured to select one or more models corresponding to the major degradation factors out of the one or more life prediction models, and determine the life prediction model for verification by combining the selected one or more models based on weights for the major degradation factors.

According to some embodiments, the weights may be calculated based on a relevance of the major degradation factors to the life of the target battery.

According to some embodiments, the life prediction device may be configured to predict a state of health (SOH) of the target battery by using the life prediction model for verification based on the initial life data of the target battery.

According to some embodiments, the life prediction device may be configured to predict the state of health based on a remaining life of the target battery according to a life cycle of the target battery.

According to some embodiments, the life prediction device may be configured to predict the state of health based on at least one of a Coulomb efficiency, a charging time, an amount of voltage change, and a charge/discharge slippage of the target battery.

According to some embodiments, the one or more life prediction models may include a machine learning model based on a convolutional neural network (CNN).

According to some embodiments, the first data may include the profile data for each battery degradation mode generated by an electrochemical model based on BOL (beginning of life) data and half-cell data on one or more batteries.

According to some embodiments, the second data may include at least one of an amount of anode degradation, an amount of cathode degradation, an amount of active lithium consumption, and an amount of resistance increase for the target battery.

In order to solve the technical problems above, a manufacturing process system for a battery in accordance with some embodiments of the present disclosure may include a manufacturing process device configured to manufacture a battery cell and inspect a quality of the manufactured battery cell, based on design specifications of the battery cell, and a life prediction system configured to predict a life of the battery cell by using one or more prediction models generated based on the design specifications of the battery cell, wherein the life prediction system is configured to predict the life of the battery cell based on profile data for each battery degradation mode predicted by the one or more life prediction models, based on initial life data of the battery cell.

In order to solve the technical problems above, a method of predicting a life of a battery in accordance with some embodiments of the present disclosure may include generating first data comprising life data of a reference battery and profile data for each battery degradation mode, generating one or more life prediction models to predict profile data for each battery degradation mode with initial life data of a target battery as input, based on the first data, generating second data comprising profile data for each battery degradation mode predicted by the one or more life prediction models based on the initial life data of the target battery, and predicting a life of the target battery based on the generated second data.

According to some embodiments, the generating the first data may include generating the profile data for each battery degradation mode generated by an electrochemical model based on BOL data and half-cell data on one or more batteries.

According to some embodiments, the one or more life prediction models may include a CNN-based machine learning model.

According to some embodiments, the second data may include at least one of an amount of anode degradation, an amount of cathode degradation, an amount of active lithium consumption, and an amount of resistance increase for the target battery.

According to some embodiments, the one or more life prediction models may include one or more models among the one or more life prediction models that correspond to major degradation factors.

According to some embodiments, the one or more models may be combined based on weights for the major degradation factors.

According to some embodiments, the weights may be calculated based on a relevance of the major degradation factors to the life of the target battery.

According to some embodiments, the predicting the life of the target battery may include predicting, by the one or more life prediction models, a remaining life of the target battery according to a life cycle of the target battery.

According to some embodiments, the predicting the life of the target battery may include predicting, by the one or more life prediction models, at least one of a Coulomb efficiency, a charging time, an amount of voltage change, and a charge/discharge slippage of the target battery.

According to some embodiments of the present disclosure, the life of the battery can be predicted by analyzing the degradation state of the battery at an early stage with the initial life data of the battery.

According to some embodiments of the present disclosure, the result data on the life prediction of the battery can be utilized in the development of battery cells.

However, aspects and features of the present disclosure are not limited to those described above, and other aspects and features not mentioned will be clearly understood by a person skilled in the art from the detailed description, described below.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIGS. 1 to 2 are block diagrams describing a life prediction system for a battery according to some embodiments of the present disclosure.
FIG. 3 is a block diagram describing a prediction model generation device according to some embodiments of the present disclosure.
FIG. 4 is a block diagram showing an information processing system used to predict the life of a battery according to some embodiments of the present disclosure.
FIGS. 5a to 5c are examples describing input/output data of the life prediction system according to a first embodiment of the present disclosure.
FIG. 6 is a flowchart describing a life prediction method for a battery according to some embodiments of the present disclosure.
FIGS. 7 and 8 are block diagrams describing a manufacturing process system for a battery according to some embodiments of the present disclosure.
FIG. 9 is a graph describing a procedure of life prediction and quality inspection of a target battery executed by a manufacturing process system for a battery according to some other embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

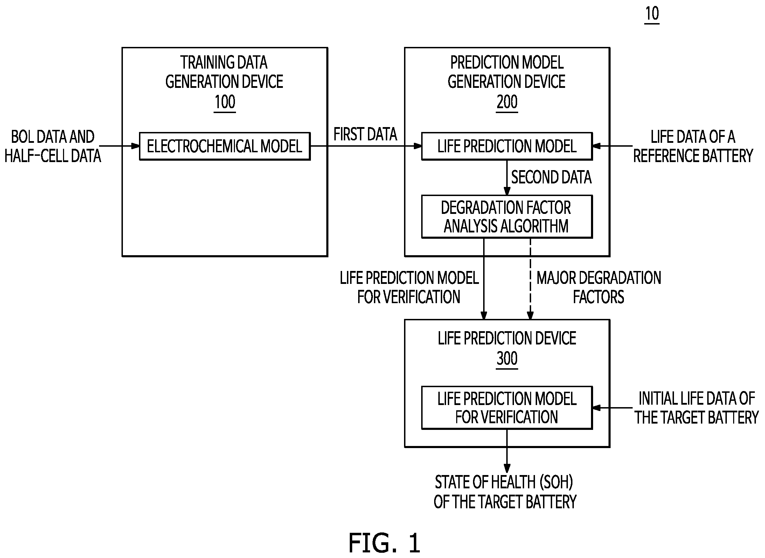

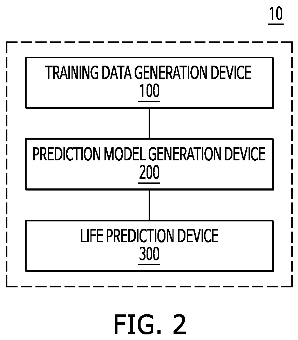

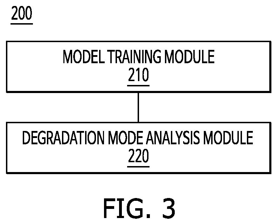

FIGS. 1 and 2 are block diagrams describing a life prediction system 10 for a battery according to some embodiments of the present disclosure. FIG. 3 is a block diagram describing a prediction model generation device 200 according to some embodiments of the present disclosure.

Referring to FIGS. 1 and 2, the life prediction system 10 may include a training data generation device 100, a prediction model generation device 200, and a life prediction device 300. Moreover, the life prediction system 10 may further include an input device that receives various data necessary for generating training data, an output device that outputs a life prediction result (e.g., a state of health of a target battery), a storage device that stores training data, a life prediction model, etc., and a communication device that performs communication with external devices.

In order to analyze the degradation factors of a battery cell according to the prior art, the ratio of the voltage change to the charge capacity change (dV/dQ) was calculated based on the voltage profile, or the battery cell was disassembled. However, such an analysis method is not only cumbersome but also has the problem of taking a long time. The life prediction system 10 according to some embodiments of the present disclosure can estimate the degradation factors of a battery cell and predict the life by inputting the initial life data of the battery cell into the life prediction system 10.

In the following description, a "reference battery" may refer to a battery capable of generating data used to train a life prediction model. Further, a "target battery" may refer to a battery that is a target for predicting a state of health, etc., through the life prediction model. Each of the reference battery and the target battery may include at least one battery cell and may be a rechargeable secondary battery. For example, each of the reference battery and the target battery may include a lithium-ion battery.

In some embodiments, the training data generation device 100 may generate first data including life data of the reference battery and profile data for each battery degradation mode. For example, the life data of the reference battery may include data such as a charge capacity and voltage measured during a predetermined life cycle of the reference battery. Here, the full life cycle of the reference battery may refer to a life cycle ranging from the BOL (beginning of life) of the reference battery to the EOL (end of life) of the reference battery. For example, the life data may be life data measured over 1000 life cycles. However, the present disclosure is merely one example and is not limited thereto, and the life data may change in the range of the predetermined life cycle depending on the type of the reference battery.

Further, the first data may include profile data for each battery degradation mode. For example, the profile data for each battery degradation mode may include, but is not limited to, anode degradation profile data, cathode degradation profile data, active lithium consumption profile data, resistance increase profile, etc. The profile data for each battery degradation mode may be generated from an electrochemical model of the battery. For example, the profile data for each battery degradation mode may be generated by inputting the BOL (beginning of life) data and half-cell data on one or more batteries into the electrochemical model of the battery. The half-cell data is data measured from a half cell configured for use in testing a battery cell, and may include anode cell data and cathode cell data. The training data generation device 100 may input the BOL data and the half-cell data into the electrochemical model, and the profile data for each battery degradation mode may be generated by the electrochemical model. Here, the profile data for each battery degradation mode may include information on at least one internal configuration of the battery or factor that affects the degradation of the battery, and may be defined from the electrochemical model of the battery.

In some embodiments, the prediction model generation device 200 may generate one or more life prediction models trained to predict profile data for each battery degradation mode of a target battery based on the first data including the life data of the reference battery and the profile data for each battery degradation mode. For example, the prediction model generation device 200 may generate a life prediction model by training with the correlation between the life data for a predetermined life cycle of the reference battery and the profile data for each battery degradation mode corresponding thereto. Further, the prediction model generation device 200 may generate life prediction models for verification corresponding to major degradation factors based on second data including profile data for each battery degradation mode outputted by the one or more life prediction models with the initial life data of the target battery as input. For example, the prediction model generation device 200 may determine major degradation factors of the battery based on the second data by using a degradation factor analysis algorithm. In this way, the life prediction models for verification may be generated based on the determined major degradation factors.

Referring to FIGS. 1 and 3, the prediction model generation device 200 may include a model training module 210 and a degradation mode analysis module 220.

In some embodiments, the model training module 210 may train the one or more life prediction models to predict profile data for each battery degradation mode with initial life data of a particular type of battery as input. For example, the model training module 210 may train the one or more life prediction models by using the first data. For example, the model training module 210 may train a life prediction model that predicts anode degradation profile data with the initial life data of the target battery as input, based on training data including the life data of the reference battery and anode degradation profile data corresponding thereto. Similarly, the model training module 210 may train a life prediction model that predicts cathode degradation profile data with the initial life data of the target battery as input, based on training data including the life data of the reference battery and cathode degradation profile data corresponding thereto. In this way, the model training module 210 may generate one or more life prediction models trained for each battery degradation mode.

Each of the one or more life prediction models may include a machine learning model based on a convolutional neural network (CNN). However, the present disclosure is not limited thereto.

In some embodiments, the degradation mode analysis module 220 may determine life prediction models for verification corresponding to the major degradation factors based on the second data. Here, the second data may include profile data for each battery degradation mode outputted by the one or more life prediction models with the initial life data of the target battery to be verified as input. For a specific example, the second data may include at least one or more of the amount of anode degradation, amount of cathode degradation, amount of active lithium consumption, and amount of resistance increase according to the life cycle (e.g., 100 initial life cycles) of the target battery, but the present disclosure is not limited thereto. That is, the second data may include basic data that enables the degradation factors of the battery according to the life cycle of the target battery to be identified. Here, the degradation factors of the battery may be data related to at least one internal state of the battery that changes during the initial life cycle.

The degradation mode analysis module 220 may select one or more models corresponding to the major degradation factors out of the one or more life prediction models based on the second data. Here, the major degradation factors may refer to degradation factors that have the greatest impact on the state of health of the target battery among a plurality of degradation factors. Specifically, the degradation mode analysis module 220 may determine one or more of the amount of anode degradation, amount of cathode degradation, amount of active lithium consumption, and amount of resistance increase (side reaction) according to the life cycle of the target battery as the major degradation factors. Further, the degradation mode analysis module 220 may assign a weight to each of the major degradation factors in proportion to the impact each of the one or more major degradation factors has on the life of the target battery. The degradation mode analysis module 220 may combine one or more life prediction models corresponding to the one or more major degradation factors based on the weights assigned to the one or more major degradation factors. Here, the weights may be calculated based on the relevance of the major degradation factors to the life of the target battery. The weights may be determined based on the correlation between the life of the target battery and the degradation factors, calculated using an appropriate degradation factor analysis algorithm such as correlation analysis.

For example, the degradation mode analysis module 220 may determine the amount of anode degradation as the major degradation factor that has the greatest impact on the life of the target battery. In this case, the degradation mode analysis module 220 may determine the life prediction model that calculates profile data for the amount of anode degradation with the initial life data of the target battery as input, as the life prediction model for verification. Or, the degradation mode analysis module 220 may assign the greatest weight to the life prediction model that calculates profile data for the amount of anode degradation with the initial life data of the target battery as input. Further, the degradation mode analysis module 220 may assign lower weights to the degradation factors other than the amount of anode degradation. By using the one or more weights thus determined to combine one or more life prediction models corresponding thereto, a life prediction model for verification may be generated.

For example, the degradation mode analysis module 220 may determine the amount of cathode degradation as a first major degradation factor that has the greatest impact on the life of the target battery, and the amount of resistance increase as a second major degradation factor that has the next greatest impact. In this case, the degradation mode analysis module 220 may assign the greatest weight to the amount of cathode degradation, and may assign a weight exceeding a threshold to a weight less than the amount of cathode degradation to the amount of resistance increase. Accordingly, the degradation mode analysis module 220 may select a life prediction model associated with the amount of cathode degradation and a life prediction model associated with the amount of resistance increase out of the life prediction models.

The degradation mode analysis module 220 may determine a life prediction model for verification based on the weights. For example, if the degradation mode analysis module 220 determines the major degradation factor as the amount of anode degradation, it may determine a life prediction model associated with the amount of anode degradation as the life prediction model for verification. In other examples, if the degradation mode analysis module 220 determines the major degradation factors as the amount of cathode degradation and the amount of resistance increase, the degradation mode analysis module 220 may determine life prediction models associated with the amount of cathode degradation and the amount of resistance increase, or a combination of these models, as the life prediction models for verification.

Then, the degradation mode analysis module 220 may transfer the determined life prediction models for verification to the life prediction device 300.

Referring again to FIGS. 1 and 2, the life prediction device 300 may predict the life of the target battery based on the initial life data of the target battery. For example, the life prediction device 300 may predict the state of health (SOH) of the target battery by inputting the initial life data of the target battery into the life prediction model for verification. Specifically, the life prediction device 300 may calculate profile data for each degradation mode by inputting the initial life data of the target battery into one or more life prediction models included in the life prediction models for verification. Further, the life prediction device 300 may calculate the remaining life by inputting the calculated profile data for each degradation mode into an appropriate function or algorithm that calculates the aging rate of the battery. The life prediction device 300 may predict the state of health based on the remaining life of the target battery according to the life cycle of the target battery thus calculated.

Further, the life prediction device 300 may calculate at least one of the Coulomb efficiency, charging time, voltage change amount, and charge/discharge slippage of the target battery based on the profile data for each degradation mode calculated by the life prediction model for verification. Moreover, the life prediction device 300 may predict the state of health based on at least one or more of the Coulomb efficiency, charging time, voltage change amount, and charge/discharge slippage of the target battery. Here, the charge/discharge slippage may refer to the amount of change in capacity in the cumulative capacity-voltage profile data. For example, the charge/discharge slippage may include a charge slippage and a discharge slippage. The charge slippage may refer to the amount of change in charge capacity in the cumulative capacity-voltage profile data, and the discharge slippage may refer to the amount of change in discharge capacity in the cumulative capacity-voltage profile data.

As described above, the life prediction system 10 for a battery according to some embodiments of the present disclosure can predict the life of a battery by analyzing the degradation state of the battery at an early stage with the initial life data of the battery. Further, the life prediction system 10 can utilize the result data on the life prediction of the battery for the development of battery cells.

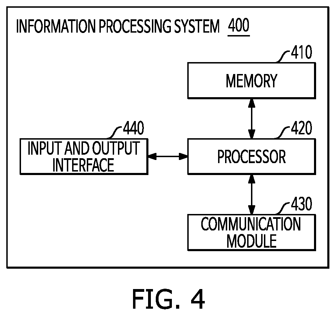

FIG. 4 is a block diagram showing an information processing system used to predict the life of a battery according to some embodiments of the present disclosure.

The information processing system 400 may correspond to the life prediction system 10 for a battery shown in FIGS. 1 and 2, for example. The information processing system 400 may include a memory 410, a processor 420, a communication module 430, and an input/output interface 440. Referring to FIG. 4, the information processing system 400 may be configured to be able to communicate information and/or data over a network using the communication module 430. According to some embodiments, the information processing system 400 may be formed of at least one device including the memory 410, the processor 420, the communication module 430, and the input/output interface 440.

The memory 410 may include any non-transitory computer-readable recording medium. According to some embodiments, the memory 410 may include a permanent mass storage device, such as read-only memory (ROM), a disk drive, a solid-state drive (SSDs), flash memory, etc. As another example, the permanent mass storage device, such as ROM, SSD, flash memory, a disk drive, etc., may be included in the information processing system 400 as a separate persistent storage device distinct from the memory 410. Further, the memory 410 may store software components including an operating system and at least one program code (e.g., code for generating and training a life prediction model installed and run in the information processing system 400, and predicting the state of health of a target battery using the life prediction model).

These software components may be loaded from a computer-readable recording medium separate from the memory 410. Such a separate computer-readable recording medium may include a recording medium directly connectable to the information processing system 400, and may include, for example, computer-readable recording media such as floppy drives, disks, tapes, DVD/CD-ROM drives, memory cards, etc. As another example, the software components may be loaded into the memory 410 via the communication module 430 rather than computer-readable recording media. For example, at least one program may be loaded onto the memory 410 based on a computer program (e.g., a program, etc., for generating and training a life prediction model, predicting the state of health of a target battery using the life prediction model, etc.) installed by files provided via the communication module 430 by developers or a file distribution system that distributes installation files of an application.

The processor 420 may be configured to process commands of computer programs by performing basic arithmetic, logic, and input/output operations. The commands may be provided to a user terminal (not shown) or another external system by the memory 410 or the communication module 430. For example, the processor 420 may receive the life data of the reference battery and/or the initial life data of the target battery, the life data of various types of batteries, etc., from one or more external devices or battery manufacturing facilities, may generate and train a life prediction model based on the life data of the reference battery and the profile data for each degradation mode, or may calculate the state of health of the target battery using the life prediction model based on the initial life data of the target battery.

The communication module 430 may provide a configuration or function for the user terminal (not shown) and the information processing system 400 to communicate with each other via a network, and may provide a configuration or function for the information processing system 400 to communicate with an external system (as one example, a separate battery manufacturing process facility, a cloud system, etc.). As one example, control signals, commands, data, etc., provided under the control of the processor 420 of the information processing system 400 may be transmitted to the user terminal and/or the external system by way of the communication module 430 and the network via the communication module of the user terminal and/or the external system. For example, the state of health of the target battery, etc., generated by the information processing system 400 may be transmitted to the user terminal and/or the external system by way of the communication module 430 and the network via the communication module of the user terminal and/or the external system. Further, the user terminal and/or the external system that has received the state of health of the target battery, etc., may output the received information via a display output-capable device.

Moreover, the input/output interface 440 of the information processing system 400 may be a means for interfacing with devices (not shown) for input or output that may be connected to the information processing system 400 or that the information processing system 400 may include. **In** FIG. 4, the input/output interface 440 is shown as an element configured separately from the processor 420 but is not limited thereto, and the input/output interface 440 may be configured to be included in the processor 420. **The** information processing system 400 may include more components than those in FIG. 4. However, there is no need to explicitly show most of the prior art components.

The processor 420 of the information processing system 400 may be configured to manage, process, and/or store information and/or data received from a plurality of user terminals and/or a plurality of external systems. According to some embodiments, the processor 420 may receive the life data of the reference battery and/or the initial life data of the target battery, the life data of various types of batteries, etc., from a user terminal and/or an external system. The processor 420 may calculate the state of health of the target battery based on the initial life data of the target battery using the life prediction model, and output the calculated state of health, etc., via a display output-capable device connected to the information processing system 400.

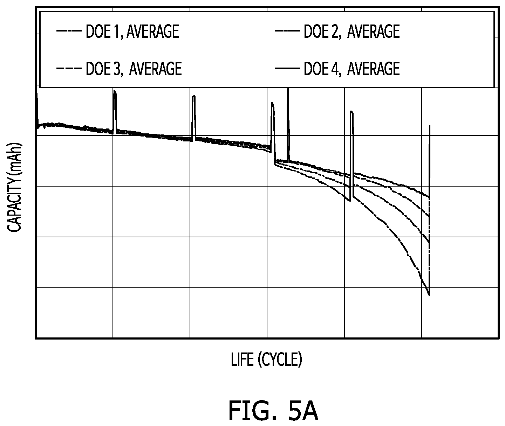

FIGS. 5a to 5c are examples describing input/output data of the life prediction system 10 according to a first embodiment of the present disclosure.

FIG. 5a is a graph showing a charge capacity according to the life of a target battery cell. Specifically, FIG. 5a is a graph showing the change in charge capacity measured during the initial life cycle for each of four design of experiments (DOEs) for one target battery. The initial life data of the target battery cell shown in FIG. 5a may be input to the life prediction system 10. For example, charge capacity data corresponding to the range of 0 to 100 life cycles of the target battery cell may be input to the life prediction model for verification of the life prediction system 10.

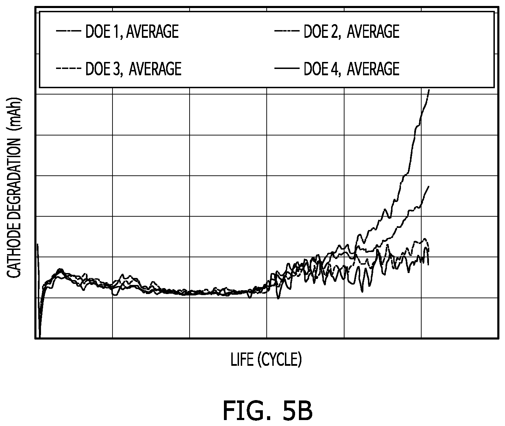

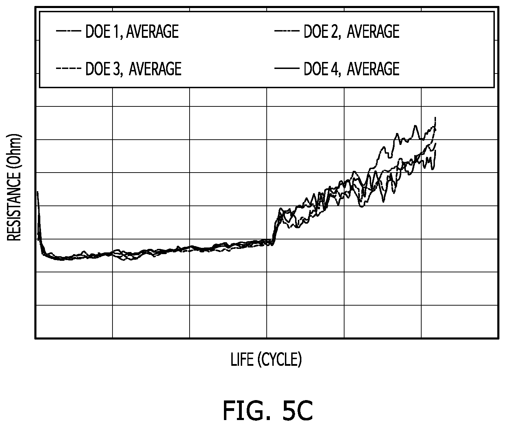

FIGS. 5b and 5c show profile data of the amount of cathode degradation and the amount of resistance increase (side reaction) calculated when the initial life data of the target battery shown in FIG. 5a is input to the life prediction model for verification. For example, the degradation mode analysis module 220 of the life prediction system 10 may determine the amount of cathode degradation and the amount of resistance increase as the major degradation factors of the target battery, and generate life prediction models for verification using two life prediction models corresponding thereto. Accordingly, the life prediction models for verification may calculate profile data of the amount of cathode degradation and the amount of resistance increase with the initial life data of the target battery as input.

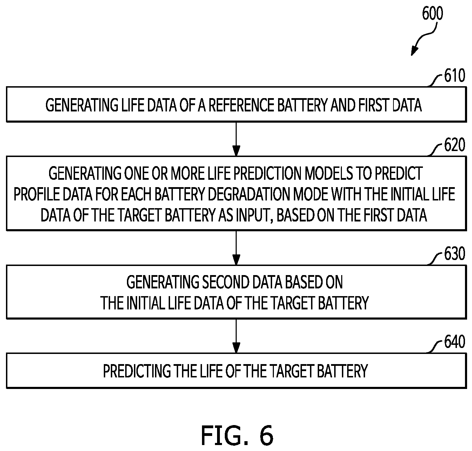

FIG. 6 is a flowchart describing a life prediction method 600 for a battery according to some embodiments of the present disclosure. The life prediction method 600 of FIG. 6 may be executed using the life prediction system 10 of FIGS. 1 and 2.

Referring to FIG. 6, the life prediction method 600 may begin with generating first data including life data of a reference battery and profile data for each battery degradation mode 610.

According to some embodiments, the generating the first data 610 may include generating profile data for each battery degradation mode generated by an electrochemical model based on the BOL data and half-cell data on one or more batteries.

Further, based on the first data, one or more life prediction models may be generated to predict profile data for each battery degradation mode with the initial life data of the target battery as input 620.

According to some embodiments, the one or more life prediction models may include a machine learning model based on a convolutional neural network (CNN).

Then, based on the initial life data of the target battery, second data including profile data for each battery degradation mode predicted by the one or more life prediction models may be generated 630.

According to some embodiments, the second data may include at least one or more of the amount of anode degradation, amount of cathode degradation, amount of active lithium consumption, and amount of resistance increase for the target battery. Further, the one or more life prediction models may include one or more models corresponding to major degradation factors among the one or more life prediction models. The one or more models may be combined based on weights for the major degradation factors. Here, the weights may be calculated based on the relevance of the major degradation factors to the life of the target battery.

The life of the target battery may be predicted based on the second data 640.

According to some embodiments, the predicting the life of the target battery 640 may include predicting a remaining life of the target battery according to the life cycle of the target battery by the one or more life prediction models. In other embodiments, the predicting the life of the target battery 640 may include predicting at least one or more of the Coulomb efficiency, charging time, voltage change amount, and charge/discharge slippage of the target battery by the one or more life prediction models.

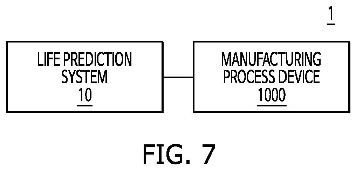

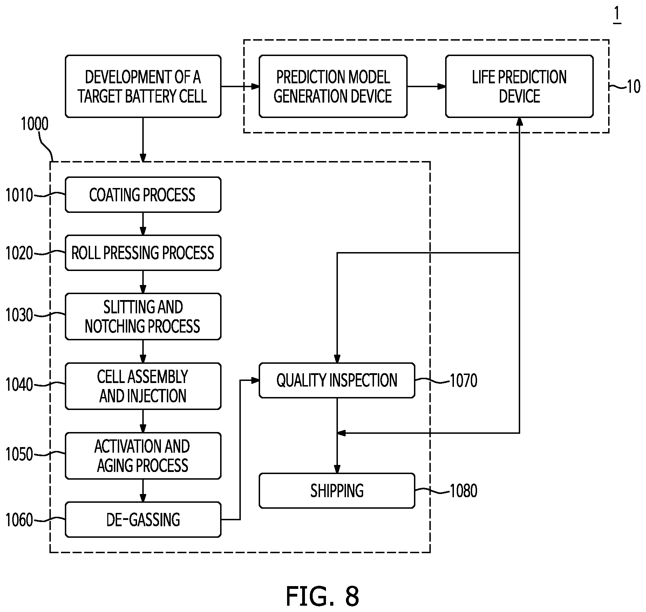

FIGS. 7 and 8 are block diagrams describing a manufacturing process system 1 for a battery according to some embodiments of the present disclosure. The life prediction system 10 of FIGS. 7 and 8 may correspond to the life prediction system 10 described in FIGS. 1 and 2. Therefore, in the following, descriptions of overlapping configurations and functions will be omitted when describing the life prediction system 10.

Referring to FIGS. 7 and 8, the manufacturing process system 1 may include a life prediction system 10 and a manufacturing process device 1000.

Referring to FIG. 7, the life prediction system 10 may predict the life of a battery cell by using one or more prediction models generated based on the design specifications of the battery cell. Specifically, the life prediction system 10 may train and generate one or more life prediction models by using first data including profile data for each battery degradation mode generated using an electrochemical model of the battery generated based on the design specifications of the battery cell and life data of a reference battery. Further, the life prediction system 10 may calculate the state of health of the target battery by inputting the initial life data of the target battery cell into the one or more life prediction models.

In some embodiments, the manufacturing process device 1000 may manufacture a battery cell based on the design specifications of the battery cell. Further, the manufacturing process device 1000 may inspect the quality of the manufactured battery cell based on the life prediction result including the state of health, etc., calculated by the life prediction system 10.

Referring to FIG. 8, the manufacturing process device 1000 may execute a battery cell manufacturing process and a quality inspection process. For example, the battery cell manufacturing process may include a coating process 1010, a roll pressing process 1020, a slitting and notching process 1030, a cell assembly and injection 1040, an activation and aging process 1050, and a de-gassing process 1060. Further, the battery cell quality inspection process may include quality inspection 1070 and shipping 1080, for example.

Specifically, the coating process 1010 may be a process of coating a slurry containing an active material of a cathode or anode, etc., on a current collector of the battery cell. The roll pressing process 1020 may be a process of flatly rolling the electrodes of the battery cell coated with active materials, etc. The slitting and notching process 1030 may be a process of cutting the electrodes to fit the size of the battery cell, and forming and processing the electrode tabs, etc. The cell assembly and injection 1040 may include a process of assembling the battery cell by inserting the electrode assembly including positive and negative electrode plates into a case and sealing it with a cap assembly, etc., and then injecting an electrolyte into the battery cell. The activation and aging process 1050 may be a process of stabilizing the battery cell by charging and discharging the battery cell. The de-gassing 1060 may be a process of removing gas inside the battery cell generated in the activation and aging process 1050.

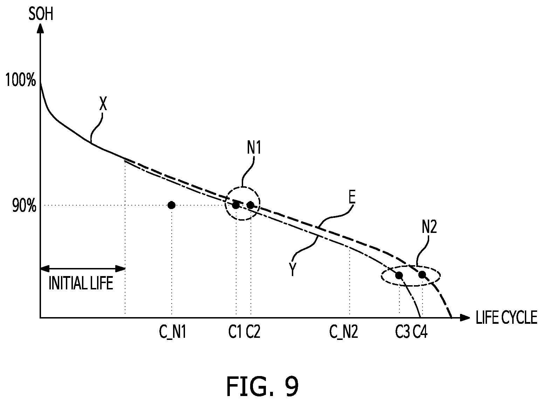

In some embodiments, if a new target battery cell is developed according to a customer's request, the life prediction system 10 may receive data on the specifications of the target battery cell. Further, the target battery cell may be manufactured by the manufacturing process device 1000 according to the specifications. When the quality inspection 1070 of the target battery cell is executed, the manufacturing process device 1000 may transfer the initial life data of the target battery cell to the life prediction system 10. The life prediction system 10 may generate a life prediction model based on profile data for each battery degradation mode according to the specifications of the target battery cell, and predict the life of the target battery cell by using the life prediction model based on the initial life data of the target battery cell. Then, the life prediction system 10 may transfer the predicted life and major degradation factors of the target battery cell to the manufacturing process device 1000. Accordingly, the manufacturing process device 1000 may determine whether the predicted life of the target battery cell satisfies the customer's request in the quality inspection 1070. If the target battery cell does not satisfy the customer's request, the manufacturing process device 1000 may remanufacture the target battery cell by changing or adjusting various manufacturing process parameters used during the manufacturing process of the target battery cell based on the received major degradation factors. In contrast, if the target battery cell satisfies the customer's request, the manufacturing process device 1000 may ship the target battery cell (1080). A specific example of the manufacturing process system 1 will be described in detail in FIG. 9.

FIG. 9 is a graph describing a procedure of life prediction and quality inspection of a target battery executed by a manufacturing process system for a battery according to some other embodiments of the present disclosure.

Referring to FIG. 9, the curve X in the graph may be the initial life data of the target battery cell. Here, the initial life data of the target battery cell may be a state of health (SOH) in the range of 1 to 100 life cycles. However, the present disclosure is not limited thereto.

The curve Y in the graph shown may be the life of the target battery cell predicted by the life prediction system 10 according to some embodiments of the present disclosure. The curve E may be the life of the target battery cell measured through actual experiments.

As a specific example, a customer who has requested the development of the target battery cell may require that the state of health (SOH) of the corresponding battery be 90% when the life cycle of the target battery cell is C_N1. Further, the customer may require that the life cycle exhibiting a sudden drop in the life state of the target battery cell be C_N2.

The manufacturing process system may check the conditions requested by the customer by utilizing the life state of the target battery calculated by the life prediction system 10 during the quality inspection of the target battery.

Referring to FIG. 9, it can be confirmed with reference to the curve Y, which is a curve representing the output life state of the life prediction system 10, that the life cycle of the target battery cell is C1 when the state of health (SOH) of the target battery cell is 90% N1. In contrast, referring to the curve E, which is an actual experimental curve, it can be confirmed that the life cycle of the target battery cell is C2. That is, it can be confirmed that the manufactured target battery cell exhibits a better life state than the customer's requirements. Further, it can be confirmed that the result obtained by predicting the life of the target battery cell by the life prediction system 10 has little difference from the actual measured life of the target battery. That is, it can be confirmed through the graph shown that the accuracy of the life prediction system 10 is 90% or higher.

Moreover, referring to the curve Y, which is the output curve of the life prediction system 10 on the graph shown, it can be confirmed that the life cycle of the target battery cell is C3 when a sudden drop N2 occurs in the target battery cell. In contrast, referring to the curve E, which is the actual experimental curve, it can be confirmed that the life cycle of the target battery cell is C4. That is, it can be confirmed that the manufactured target battery cell exhibits a better life state than the customer's requirements. Further, it can be confirmed through the graph shown that the result obtained by predicting the life of the target battery cell by the life prediction system 10 does not have a large difference from the actual measured life of the target battery.

As described above, the life prediction system 10 for a battery according to some embodiments of the present disclosure can predict the life of a battery by analyzing the degradation state of the battery at an early stage with the initial life data of the battery. Further, the life prediction system 10 can utilize the result data on the life prediction of the battery for the development and process of battery cells.

Although the present disclosure has been described with reference to embodiments and drawings illustrating aspects thereof, the present disclosure is not limited thereto. Various modifications and variations can be made by a person skilled in the art to which the present disclosure belongs within the scope of the technical spirit of the present disclosure and the claims and their equivalents, below.

### DESCRIPTION OF SOME REFERENCE SYMBOLS

1: Manufacturing process system
10: Life prediction device
100: Training data generation device
200: Prediction model generation device
210: Model training module
220: Degradation mode analysis module
300: Life prediction device
400: Information processing system
1000: Manufacturing process device

## Claims

1. A system (10) for predicting a life of a battery, comprising:
a training data generation device (100) configured to generate first data comprising life data of a reference battery and profile data for each battery degradation mode;
a prediction model generation device (200) configured to generate one or more life prediction models to predict profile data for each battery degradation mode with initial life data of a target battery as input, based on the first data; and
a life prediction device (300) configured to predict a life of the target battery based on second data comprising profile data for each battery degradation mode predicted by the one or more life prediction models based on the initial life data of the target battery.

2. The system as claimed in claim 1, wherein the prediction model generation device (200) comprises:
a model training module (210) configured to train the one or more life prediction models to predict profile data for each battery degradation mode with the life data of the reference battery as input, based on the first data; and
a degradation mode analysis module (220) configured to determine a life prediction model for verification corresponding to major degradation factors based on the second data comprising profile data for each battery degradation mode outputted by the one or more life prediction models with the initial life data of the target battery as input.

3. The system as claimed in claim 2, wherein the degradation mode analysis module (220) is configured to:
select one or more models corresponding to the major degradation factors out of the one or more life prediction models, and
determine the life prediction model for verification by combining the selected one or more models based on weights for the major degradation factors.

4. The system as claimed in claim 3, wherein the weights are calculated based on a relevance of the major degradation factors to the life of the target battery.

5. The system as claimed in any one of the claims 2 to 4, wherein the life prediction device (300) is configured to predict a state of health, SOH, of the target battery by using the life prediction model for verification based on the initial life data of the target battery.

6. The system as claimed in claim 5, wherein the life prediction device (300) is configured to predict the state of health based on a remaining life of the target battery according to a life cycle of the target battery.

7. The system as claimed in claim 6, wherein the life prediction device (300) is configured to predict the state of health based on at least one of a Coulomb efficiency, a charging time, an amount of voltage change, and a charge/discharge slippage of the target battery.

8. The system as claimed in any one of the preceding claims, wherein the one or more life prediction models comprise a machine learning model based on a convolutional neural network, CNN.

9. The system as claimed in any one of the preceding claims, wherein the first data comprises the profile data for each battery degradation mode generated by an electrochemical model based on beginning of life, BOL, data and half-cell data on one or more batteries.

10. **The** system as claimed in any one of the preceding claims, wherein the second data comprises at least one of an amount of anode degradation, an amount of cathode degradation, an amount of active lithium consumption, and an amount of resistance increase for the target battery.

11. A manufacturing process system (1) for a battery, comprising:
a manufacturing process device (1000) configured to manufacture a battery cell and inspect a quality of the manufactured battery cell in the quality inspection step (1070), based on design specifications of the battery cell; and
a life prediction system (10) configured to predict a life of the battery cell by using one or more prediction models generated based on the design specifications of the battery cell,
wherein the life prediction system (10) is configured to predict the life of the battery cell based on profile data for each battery degradation mode predicted by the one or more life prediction models, based on initial life data of the battery cell.

12. A method (600) of predicting a life of a battery, as described in the flowchart, comprising:
generating first data comprising life data of a reference battery and profile data for each battery degradation mode, which is step (610);
generating one or more life prediction models to predict profile data for each battery degradation mode with initial life data of a target battery as input, based on the first data, which is step (620);
generating second data comprising profile data for each battery degradation mode predicted by the one or more life prediction models based on the initial life data of the target battery, which is step (630); and
predicting a life of the target battery based on the generated second data, which is step (640).

13. The method as claimed in claim 12, wherein the step of generating the first data (610) comprises:
generating the profile data for each battery degradation mode generated by an electrochemical model based on BOL data and half-cell data on one or more batteries.

14. The method as claimed in claim 12 or 13, wherein the one or more life prediction models comprise a CNN-based machine learning model.

15. The method as claimed in any one of the claims 12 to 14, wherein the second data comprises at least one of an amount of anode degradation, an amount of cathode degradation, an amount of active lithium consumption, and an amount of resistance increase for the target battery.
